# EUROPEAN PATENT SPECIFICATION

(11) **EP 2 327 741 B1**
(45) Date of publication and mention of the grant of the patent: **06.12.2017**
(21) Application number: 10189254.5
(22) Date of filing: 28.10.2010
(51) Int. Cl.: C08K 5/00, H01B 1/22, H01L 31/0224

(54) **Conductive paste with surfactants**
Leitfähige Paste mit Tensiden
Pâte conductrice à tensioactifs

(30) Priority: 29.10.2009 TW 098136633
(43) Date of publication of application: 01.06.2011
(73) Proprietor: GIGA SOLAR MATERIALS CORPORATION, Hsinchu County 30351 (TW)
(72) Inventor: Chao, Chu-Lung, Hsinchu County 30351 (TW); Chang, Yu-Chen, Hsinchu County 30351 (TW); Cheng, Chong-Chieh, Hsinchu County 30351 (TW); Lu, Ying-Chih, Hsinchu County 30351 (TW); Lin, Cheng-Hsun, Hsinchu County 30351 (TW); Huang, Wen-Jui, Hsinchu County 30351 (TW)
(74) Representative: Becker Kurig Straus

(56) References cited:
- EP-A2- 1 184 881
- US-A1- 2004 245 507
- US-A1- 2009 266 409
- DATABASE WPI Week 200910 Thomson Scientific, London, GB; AN 2009-B37242 XP002629388, & CN 101 295 739 A (BYD CO LTD) 29 October 2008 (2008-10-29)

## Description

### Field of the Invention

The present invention relates to a conductive paste with a surfactant.

### Background of the Invention

Since conductive paste can be cured instantly or quickly, conveniently manipulated, and forms a layer which is usually smaller than conventional connecting elements such as pins, it is often used in electronic products. Solar cells which use single-crystal Si or poly Si as their main semiconductor substrate have electrodes which use conductive pastes made of mixed metal powders and organic carriers applied on Si wafers by screen printing and sintered in sintering furnaces. Accordingly, the composition and the sintering conditions of the conductive paste are especially critical to the solar cells.

U.S. Patent Application Publication No. US 2004/0245507 A1 discloses an example of a metal powder paste whose particles are coated with an organic metal compound which is not ideal for the composition and the sintering conditions of the conductive paste especially critical to the solar cells.

Generally speaking, a conductive paste includes an organic carrier, conductive powders, glass frits, and optional additives. The components in the conductive paste dominate the shape after printing, the conductivity of the electrodes, adherence to the semiconductor substrate, and etching of the anti-reflective layer.

The above-said glass frit usually includes some ingredients to etch the anti-reflective layer and to assist the sintering during the thermal sintering process. However, such ingredients and the glass itself are pollutants and harmful to the environment during the manufacture and usage.

### Summary of the Invention

This in mind, the present invention aims at providing an environment-friendly conductive paste that keeps the solar cell stable, maintains high conversion yield, and makes it less harmful to the environment.

This is achieved by a conductive paste according to claim 1. The dependent claims pertain to corresponding further developments and improvements.

The present invention accordingly proposes a conductive paste for use in electronic products. In particular, the conductive paste of the present invention is particularly useful in the electrodes of solar cells.

The present invention proposes a conductive paste which includes at least one metal in powder form, an organic carrier, glass frit and a surfactant. The surfactant has a representative formula as follows:

Mx(R)y(Q)z

wherein, M is a metal material or a semiconductive element, such as Al, Ti, Zr or Si ... etc.; R is hydrophilic group which is directly connected to M, and R is capable of being hydrolyzed by water to form a corresponding hydrophilic functional group, such as alkyl oxide group, carbonyl group, carboxyl group, carbonyloxy group, or amido group; and Q is a hydrophobic group with 1-24 carbon atoms, and Q may be a stable and less reactive alkyl group or alkoxy group, or includes a functional group which is capable of reacting with other polymeric units or moieties, such as vinyl group, aliphatic epoxy group, styryl group, methacryloxy group, acryloxy group, aliphatic amino group, chloropropyl group, aliphatic mercapto group, aliphatic sulfido group, isocyanato group, aliphatic ureido group, aliphatic carboxyl group, aliphatic hydroxyl group, cyclohexyl group, phenyl group, aliphatic formyl group, acetyl group, or benzoyl group.

Due to the functional groups which are capable of reacting with other polymeric units, there may be one or more surfactants of the present invention which are linked to one polymeric chain such as Mx(R)y(Q)z. The surfactant which is attached to a polymeric chain may be one or more.

The surfactant of the present invention has a representative formula as follows:

Mx(R)y(Q)z

wherein, X, Y and Z are all natural numbers.

Because the conductive paste of the present invention employs a specially designed surfactant, the hydrophilic group R in the surfactant may turn into another hydrophilic functional group after being hydrolyzed by water, but the hydrophobic group Q has greater affinity to organic solvents or is prone to react with polymers. The hydrophilic functional group in the surfactant is prone to attach to the surface of metals and the other hydrophobic group Q has greater affinity to organic solvents. In such a way, metal powders may be accordingly well dispersed. Furthermore, the glass content may become lower as compared to the conventional conductive paste when the surfactant is added into the conductive paste so that it introduces less contaminants into the environment.

These and other objectives of the present invention will no doubt become obvious to those of ordinary skill in the art after reading the following detailed description of the preferred embodiment that is illustrated in the various figures and drawings.

### Brief Description of the Drawings

In the following, the invention is further illustrated by way of example, taking reference to the accompanying drawings. Thereof
FIG. 1 illustrates a reaction in which the surfactant of the present invention bonds with a side chain of a polymer,
FIG. 2 illustrates the hydrolysis reaction of Formula 1,
FIG. 3 illustrates the hydrolysis reaction of Formula 2,
FIG. 4 (Table 1 to Table 3) illustrates the compositions of the conductive paste with the addition of the surfactant of Formula 1 of the present invention, and
FIG. 5 (Table 4) illustrates the results of electric properties, tensile and bow reduction between examples and comparative examples in Table 1 to Table 3.

### Detailed Description

The present invention provides a conductive paste which includes at least one metal material in powder form, an organic carrier, optional glass, and a surfactant. The metal material may be A1 powder or Ag powder. The organic carrier may be dissolved resins in an organic solvent with optional oil acid or other additives. The glass may be an amophorous compound containing metals in various oxide forms, mainly for etching the anti-reflective of solar cells and to assist the sintering during the thermal sintering process. To meet different demands, different glass may be added or no glass is added.

The surfactant which is provided by the present invention has a representative formula as follows:

Mx(R)y(Q)z ..... representative formula 1

wherein X is between 1 and 6, Y is between 1 and 20, Z is between 1 and 20, M is a metal material or a semiconductive element, such as Al, Ti, Zr, Si, Ge or other metal materials and semiconductive elements, R is hydrophilic group which is directly connected to M, and R is capable of being hydrolyzed by water to form a corresponding hydrophilic functional group. In accordance with some embodiments of the present invention, R may independently be an alkyl oxide group (-O-CmHn), carbonyl group (-(C=O)- CmHn), carboxyl group (-O-(C=O)- CmHn), carbonyloxy group (-(C=O)O- CmHn), amido group(-(C=O)NH- CmHn), alkoxylene group(-O- CmHn -0-) and carboxylic ester group(-O-(C=O)- CmHn -O-). Generally speaking, m may be between 1 and 6, n may be between 3 and 13, and CmHn may be a branched or unbranched alkyl or cycloalkyl group. The alkoxylene group may be ethoxylene (-O-CH2-CH2-O-), and the carboxylic ester group may be (-O-(C=O)-CH2-O-). Q is a hydrophobic group with 1-24 carbon atoms. Q also may be a stable and less reactive alkyl group or alkoxy group, or include a functional group which is capable of reacting with other polymeric units or moieties, such as a vinyl group, aliphatic epoxy group, styryl group, methacryloxy group, acryloxy group, aliphatic amino group, chloropropyl group, aliphatic mercapto group, aliphatic sulfido group, isocyanato group, aliphatic ureido group, aliphatic carboxyl group, aliphatic hydroxyl group, cyclohexyl group, phenyl group, aliphatic formyl group, acetyl group or benzoyl group. The aliphatic group may have 1-24 carbon atoms, such as a branched or unbranched alkyl group.

In addition to this, Q may also be a compound including N, 0, P S, or any combination thereof. In some circumstances, Q may have at least one lone pair which M may accept so that Q is a ligand when M is a metal. Furthermore, Q is capable of being chemically bonded to be a side chain or a terminal of a polymer chain by means of chemical reaction through the functional group, which means a polymeric chain may connect one or more functional groups of the surfactant Mx(R)y. In other words, the surfactant which is attached to a polymeric chain is not limited to just one type. As long as a polymeric chain is able to react with Q, it is a suitable polymeric chain. The polymeric chain may have 1 to 10000 polymeric units.

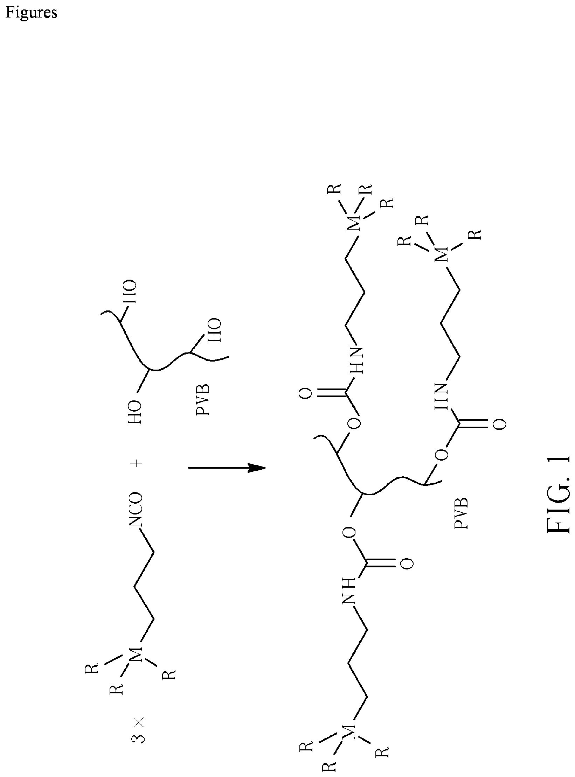

FIG. 1 illustrates a reaction in which the surfactant of the present invention bonds with a side chain of a polymer. As shown in FIG. 1, the side chain of a polymer has hydroxyl groups -OH. The polymer may be a polyvinyl alcohol (PVA) or a polyvinyl butyral (PVB). Taking PVB for example as shown in FIG. 1, the polymer reacts with Q having isocyanate group,-NCO, to form a urethane group, -NH-CO-O-, which makes Mx(R)y attached to the polymer.

A preferred embodiment of the representative formula 1 of the present invention may be the compound of formula 1, formula 2, formula 3 or formula 4.
formula 1

Since Q is (O-C(CH3)-CH-CO-O-C18H15), Z is 1. In formula 1, on one hand Q is bonded to M. And on the other hand, Q may also serve asa ligand, a bidentate for instance so that Q and M have coordination bonding to each other. In addition, in accordance with the demands different products R may be selected from different hydrophilic groups. For example, one of R may be an isopropoxy group and the other R

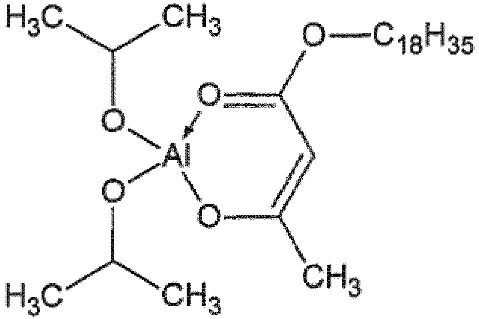

In formula 1, M is illustrated as Al. As a result, X is 1. R is an isopropoxy group, e.g. (CH3)2CHO- which is attached to Al. There are two isopropoxy groups therein, so Y is 2.

may be another group such as a carbonyl group or a carboxyl group.

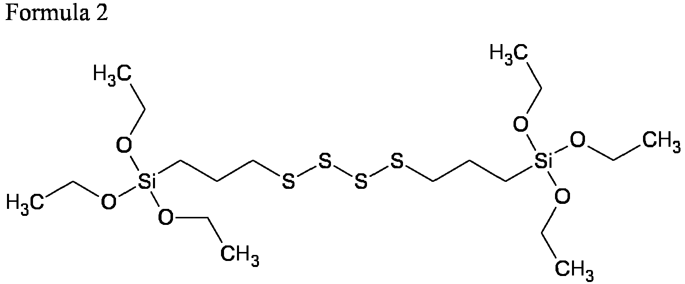

In formula 2, X is 2 since M is illustrated as Si. R is an ethoxy group, i.e. -0-C2H5, so Y is 6. Q is C3H6S2 so Z is 2. In formula 2, Q is a divalent group which is capable of bonding to two independent Ms, and there are hetero-atoms in Q, S for example.

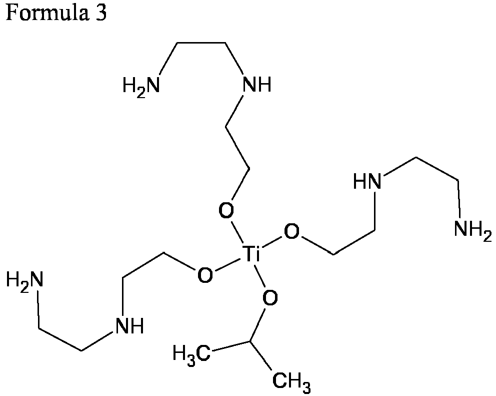

In formula 3, X is 1 because M is illustrated as Ti. R is an isopropoxy group, i.e. (CH3)2CHO-, so Y is 1. Q is -OC2H4NHC2H4NH2 so Z is 3.

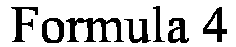

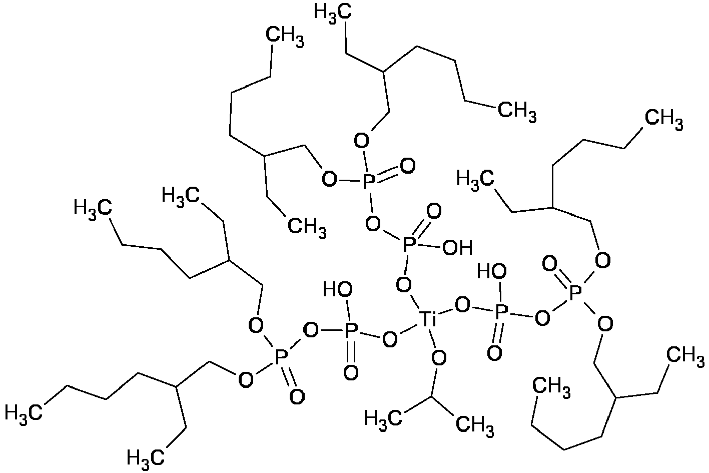

In formula 4, X is 1 because M is illustrated as Ti. R is an isopropoxy group, i.e. (CH3)2CHO-, so Y is 1. Q is -P2O5H-(OC8H17)2 so Z is 3.

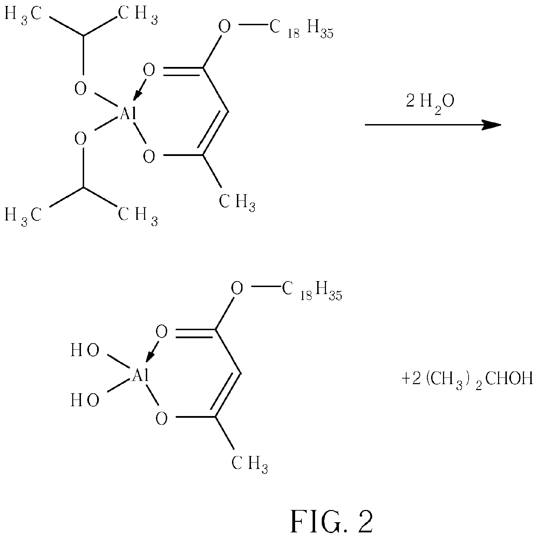

FIG. 2 illustrates the hydrolysis reaction of Formula 1. As shown in FIG. 2, taking Formula 1 for example, water in an organic carrier may hydrolyze Formula 1 when Formula 1 is in contact with the organic carrier. The original (CH3)2CO-)2 group in R which reacted with water molecules now turns into (HO-)2 groups which correspond to the original (CH3)2CO-)2 group. At this moment, (HO-)2 groups may adsorb onto the surface of metal powders and the hydrophobic group Q is dissolved in the organic carrier.

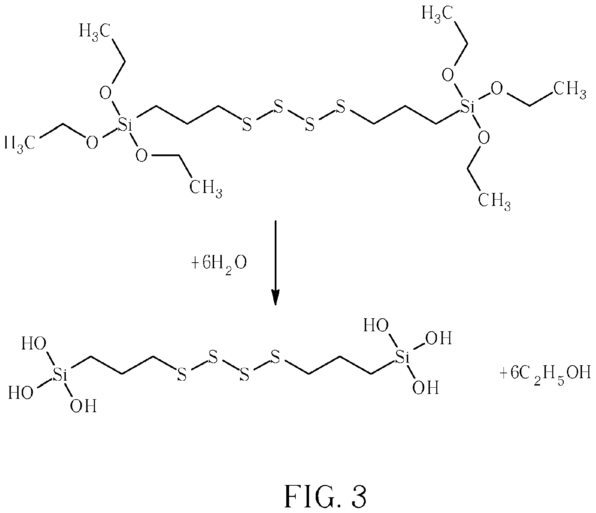

FIG. 3 illustrates the hydrolysis reaction of Formula 2. As shown in FIG. 3, R in Formula 2 is an ethoxy group, i.e. -0-C2H5. After reacting with water molecules, it turns into (HO-)2 groups which corresponds to the original ethoxy group. At this moment, (HO-)2 groups may adsorb onto the surface of metal powders and the hydrophobic group Q (C3H6S2) is dissolved in the organic carrier.

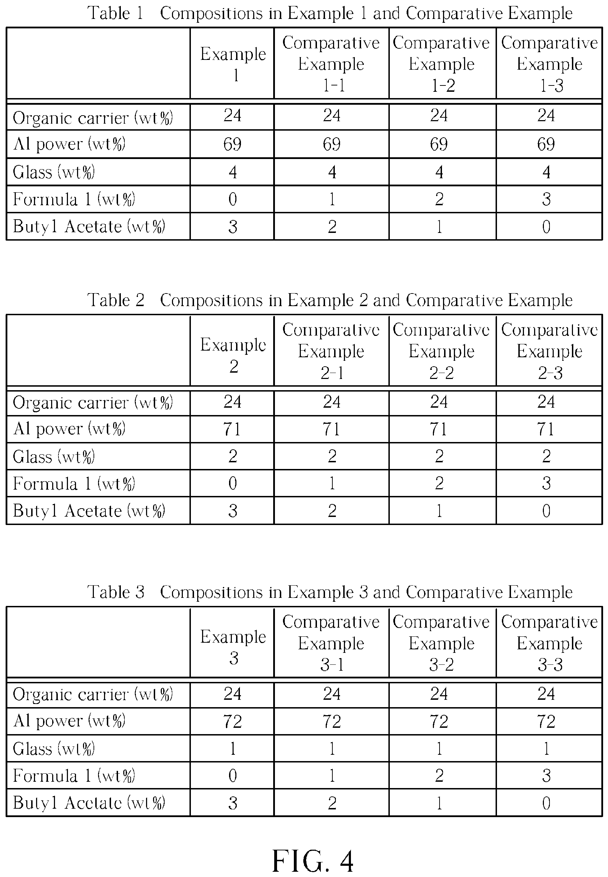

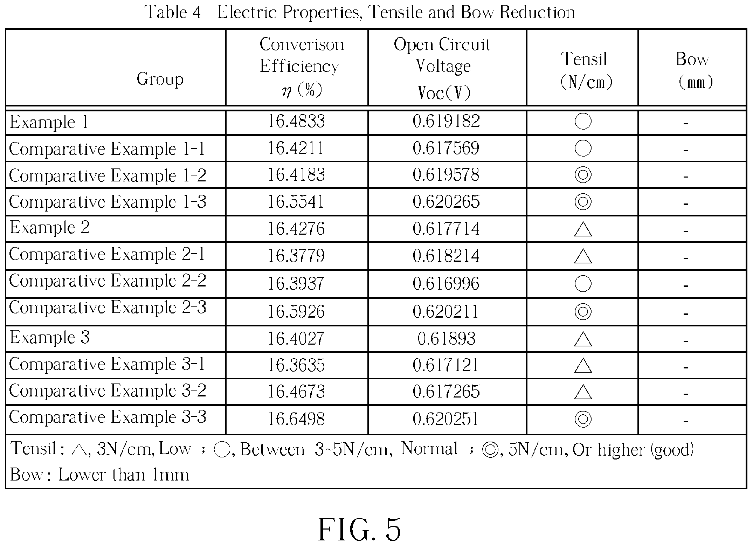

Table 1 to Table 3 in FIG. 4 illustrate the compositions of the conductive paste with the addition of the surfactant of Formula 1 of the present invention. Table 4 in FIG. 5 illustrates the results of electric properties, tensile, and bow reduction between examples and comparative examples in Table 1 to Table 3.

As shown in FIG. 4, under the circumstance of higher glass content (4%), the addition of surfactant may increase the tensile. Under the circumstance of lower glass content (1%-2%), the surfactant may also increase the tensile to an acceptable extent which meet the requirements of this field without affecting the electrical properties.

Accordingly, the surfactant of the present invention not only can effectively disperse the metal powders, but also 10% (wt.%) or less, preferably 0.1%-5% (wt.%), surfactant in the conductive paste is sufficiently effective. In the conventional methods, there is no other way to increase the connection between the electrodes of the solar cells and the semiconductor substrate in addition to the addition of glass into the conductive paste. However, in the presence of the conductive paste of the present invention, less glass is required. Less glass does less harm to the environment and makes no harm to the connection between the electrodes of the solar cells and the semiconductor substrate. Further, the efficiency of solar cells keeps substantially unchanged. Moreover, the conductive paste of the present invention may not only be used in solar cells, but also may be used in other electronic elements such as ceramic capacitors, semiconductor packaging, or printed circuit boards.

## Claims

1. A conductive paste comprising:
at least one metal powder;
an organic carrier;
a glass; and
**characterized by**
a surfactant having a representative formula as follows:
Mx(R)y(Q)z,
wherein M is selected from a group consisting of a metal material and a semiconductive element; R is selected from the following group: alkyl oxide group (-O-CmHn), carbonyl group (-(C=O)- CmHn), carboxyl group (-O-(C=O)- CmHn), carbonyloxy group (-(C=O)O- CmHn), amido group(-(C=O)NH- CmHn), alkoxylene group(-O- CmHn -O-) and carboxylic ester group(-O-(C=O)- CmHn -0-); and Q is selected from the following groups: vinyl group, aliphatic epoxy group, styryl group, methacryloxy group, acryloxy group, aliphatic amino group, chloropropyl group, aliphatic mercapto group, aliphatic sulfido group, isocyanato group, aliphatic ureido group, aliphatic carboxy group, aliphatic hydroxyl group, cyclohexyl group, phenyl group, aliphatic formyl group, acetyl group and benzoyl group, wherein X is between 1-and-6, Y is between 1 and 20, and Z is between 1 and 20.

2. The conductive paste of claim 1, further **characterized in that** Q has a lone pair which M accepts to be a ligand.

3. The conductive paste of claims 1 or 2, further **characterized in that** M comprises at least one of Al, Ti, Zr, and Si.

4. The conductive paste of claim 1, further **characterized in that** m is between 1, and 6.

5. The conductive paste of claim 1, further **characterized in that** n is between 3 and 13.

6. The conductive paste of claim 1, further **characterized in that** when an aliphatic group is selected as Q, said aliphatic group comprises 1 to 24 carbon atoms.

7. The conductive paste of claims 1, 2, 3, or 6, further **characterized in that** Q is chemically bonded to a side chain or a terminal of a polymer chain by means of a chemical reaction.

8. The conductive paste of claim 8, further **characterized in that** said polymer chain has 1 to 10000 polymeric units.

9. The conductive paste of claims 1, 2, 3, 6, 7, or 8 further **characterized by** comprising 10% or less of said surfactant.

## Patentansprüche

1. Leitfähige Paste, welche umfasst:
mindestens ein Metallpulver;
einen organischen Träger;
ein Glas;
und die **gekennzeichnet ist durch**
ein oberflächenaktives Mittel, welches die folgende allgemeine Formel aufweist:
Mx(R)y(Q)z,
worin M ausgewählt ist aus der Gruppe bestehend aus einem Metallmaterial und einem halbleitenden Element;
R ausgewählt ist aus den folgenden Gruppen: Alkyloxid-Gruppe (-O-CmHn), Carbonyl-Gruppe (-(C=O)-CmHn), Carboxy-Gruppe (-O-(C=O)-CmHn), Carbonyloxy-Gruppe (-(C=O)O-CmHn), Amido-Gruppe (-(C=O)NH-CmHn), Alkoxylene-Gruppe (-O-CmHn-O-) und Carbonsäureester-Gruppe (-O-(C=O)-CmHn-O-); und
Q ausgewählt ist aus den folgenden Gruppen: Vinyl-Gruppe, aliphatischer Epoxy-Gruppe, Styryl-Gruppe, Methacryloxy-Gruppe, Acryloxy-Gruppe, aliphatischer Amino-Gruppe, Chlorpropyl-Gruppe, aliphatischer Mercapto-Gruppe, aliphatischer Sulfid-Gruppe, Isocyanat-Gruppe, aliphatischer Ureid-Gruppe, aliphatischer Carboxy-Gruppe, aliphatischer Hydroxy-Gruppe, Cyclohexyl-Gruppe, Phenyl-Gruppe, aliphatischer Formyl-Gruppe, Acetyl-Gruppe und Benzoyl-Gruppe, worin X zwischen 1 und 6 ist, Y zwischen 1 und 20 ist, und Z zwischen 1 und 20 ist.

2. Leitfähige Paste nach Anspruch 1, weiter **gekennzeichnet dadurch, dass** Q ein freies Elektronenpaar aufweist, das M als Ligand annimmt.

3. Leitfähige Paste nach Anspruch 1 oder 2, weiter **gekennzeichnet dadurch, dass** M mindestens einen von Al, Ti, Zr, und Si umfasst.

4. Leitfähige Paste nach Anspruch 1, weiter **gekennzeichnet dadurch, dass** m zwischen 1 und 6 ist.

5. Leitfähige Paste nach Anspruch 1, weiter **gekennzeichnet dadurch, dass** n zwischen 3 und 13 ist.

6. Leitfähige Paste nach Anspruch 1, weiter **gekennzeichnet dadurch, dass** wenn eine aliphatische Gruppe als Q gewählt wird, die aliphatische Gruppe 1 bis 24 Kohlenstoffatome umfasst.

7. Leitfähige Paste nach Anspruch 1, 2, 3, oder 6, weiter **gekennzeichnet dadurch, dass** Q mittels einer chemischen Reaktion chemisch an eine Seitenkette oder ein Ende eines Polymers gebunden ist.

8. Leitfähige Paste nach Anspruch 7, weiter **gekennzeichnet dadurch, dass** die Polymerkette 1 bis 10.000 Polymereinheiten aufweist.

9. Leitfähige Paste nach Anspruch 1, 2, 3, 6, 7 oder 8 weiter **gekennzeichnet dadurch, dass** das oberflächenaktive Mittel zu 10% oder weniger enthalten ist.

## Revendications

1. Pâte conductrice comprenant :
au moins une poudre métallique ;
un support organique ;
du verre ; et
**caractérisée en ce qu'**elle comprend
un tensioactif présentant une formule représentative comme suit :
Mx(R)y(Q)z,
M étant choisi dans un groupe constitué d'un matériau métallique et d'un élément semi-conducteur ; R étant choisi dans le groupe suivant : un groupe oxyde d'alkyle (-0-CmHn), un groupe carbonyle (-(C=O)-CmHn), un groupe carboxyle (-O-(C=O)-CmHn), un groupe carbonyloxy (-(C=O)O-CmHn), un groupe amido (-(C=O)NH-CmHn), un groupe alcoxylène (-O-CmHn-O-) et un groupe ester carboxylique (-O-(C=O)-CmHn-O-) ; et Q étant choisi parmi les groupes suivants : un groupe vinyle, un groupe époxy aliphatique, un groupe styryle, un groupe méthacryloxy, un groupe acryloxy, un groupe amino aliphatique, un groupe chloropropyle, un groupe mercapto aliphatique, un groupe sulfido aliphatique, un groupe isocyanato, un groupe uréido aliphatique, un groupe carboxy aliphatique, un groupe hydroxyle aliphatique, un groupe cyclohexyle, un groupe phényle, un groupe formyle aliphatique, un groupe acétyle et un groupe benzoyle, x étant situé entre 1 et 6, y étant situé entre 1 et 20 et z étant situé entre 1 et 20.

2. Pâte conductrice selon la revendication 1, en outre **caractérisée en ce que** Q présente une paire isolée que M accepte comme ligand.

3. Pâte conductrice selon les revendications 1 ou 2, en outre **caractérisée en ce que** M comprend au moins un élément parmi Al, Ti, Zr et Si.

4. Pâte conductrice selon la revendication 1, en outre **caractérisée en ce que** m est situé entre 1 et 6.

5. Pâte conductrice selon la revendication 1, en outre **caractérisée en ce que** n est situé entre 3 et 13.

6. Pâte conductrice selon la revendication 1, en outre **caractérisée en ce que**, lorsqu'un groupe aliphatique est sélectionné en tant que Q, ledit groupe aliphatique comprend de 1 à 24 atomes de carbone.

7. Pâte conductrice selon les revendications 1, 2, 3 ou 6, en outre **caractérisée en ce que** Q est lié chimiquement à une chaîne latérale ou à une chaîne d'extrémité d'un polymère au moyen d'une réaction chimique.

8. Pâte conductrice selon la revendication 7, en outre **caractérisée en ce que** ladite chaîne polymère présente de 1 à 10.000 unités polymères.

9. Pâte conductrice selon les revendications 1, 2, 3, 6, 7 ou 8, en outre **caractérisée en ce qu'**elle comprend 10 % ou moins dudit tensioactif.
